# EUROPEAN PATENT APPLICATION

(11) **EP 1 760 889 A2**
(43) Date of publication of application: **07.03.2007**
(21) Application number: 06023198.2
(22) Date of filing: 30.03.2005
(51) Int. Cl.: H03K 19/0185

(54) **High speed input circuit**

(30) Priority: 06.04.2004 KR 20040023339; 14.05.2004 KR 20040034287
(62) Divisional of application: 05251961.8
(71) Applicant: Samsung Electronics Co., Ltd., Suwon-si, Gyeonggi-Do (KR)
(72) Inventor: Lee, Seung-hoon, 336-805 Cheongmyeong, Yeongtong-gu Suwon-si, Gyeonggi-do (KR); Kwon, Kee-won, Bundang-gu Seongnam-si Gyeonggi-do (KR); Choi, Jung-hwan, Paldal-gu Suwon-si Gyeonggi-do (KR)
(74) Representative: Mounteney, Simon James

(57) **Abstract**

A high speed differential input circuit (600) includes input nodes (IN1,IN2) for receiving input signals (RXP,RXN), a termination circuit (610), a comparing circuit (620) and a current source (630). The current source (630) is responsive to a clock signal (CLK). The termination circuit (610) includes PMOS transistors (P61,P62,P63), termination resistors (Rt61,Rt62) and normal mode resistors (Rn61,Rn62) which influence the swing widths of the input signals (RXP,RXN). The PMOS transistors (P61,P62,P63) are responsive to a swing width control signal (TE). When the PMOS transistors (P61,P62,P63) are turned on, the swing widths of the input signals (RXP,RXN) are limited. In contrast, when the PMOS transistors (P61,P62,P63) are turned off, a full swing width of the input signals (RXP,RXN) is preserved.

## Description

### Field of the Invention

The present invention relates to integrated circuit devices and, more particularly, to high speed output driver circuits.

### Background of the Invention

A conventional integrated circuit device may include a plurality of output driver circuits that are configured to drive on-chip or off-chip loads at high data rates. These output driver circuits may be single stage devices having a pull-down transistor connected to a pull-up load (e.g., resistor, depletion-mode transistor, etc.). The pull-down transistor may have a gate terminal responsive to an input signal, a drain terminal coupled to an output of the driver circuit and a source terminal coupled to a reference supply line (e.g., Vss). The resistor may be electrically coupled between the output of the driver circuit and a positive power supply line (e.g., Vdd). During operation, the input signal may have a full swing width and thereby swing rail-to-rail between Vss and Vdd. The output signal at the output of the driver circuit may also have a full swing width. One example of a conventional output driver circuit is disclosed in U.S. Patent No. 6,130,563.

A single stage output driver circuit may utilize a large pull-down transistor in order to drive a high capacitance load with an output signal having a full swing width. Unfortunately, using such a large pull-down transistor to switch an output signal rail-to-rail may limit an operating speed of the output driver circuit. To address this speed limitation, output driver circuits having multiple stages have been developed for high speed applications. In such driver circuits, the signal swing widths of the signals generated at the outputs of one or more of the stages may be smaller to thereby support higher switching rates.

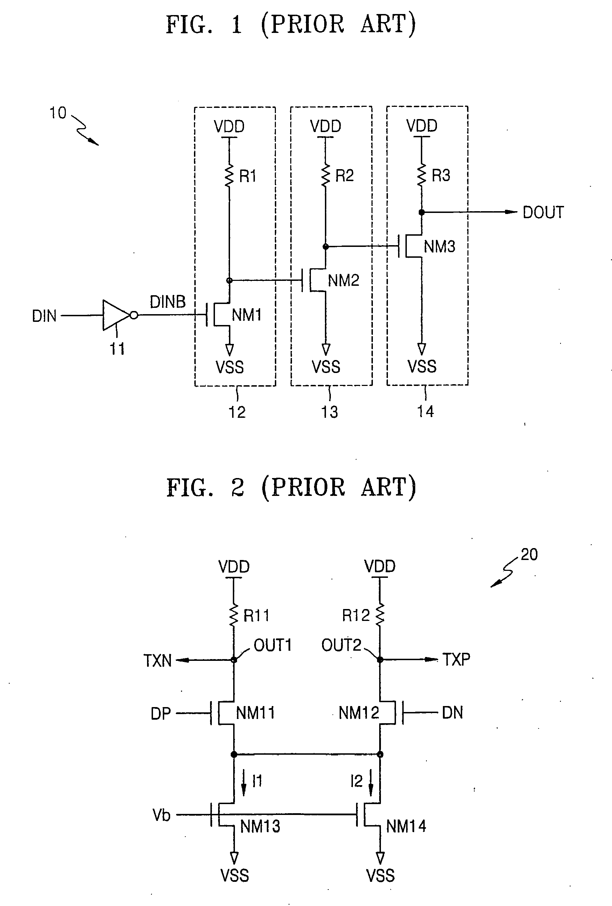

FIG. 1 is an electrical schematic of a conventional output driver circuit **10** having multiple driver stages. These stages are illustrated as an input driver stage **12,** an intermediate driver stage **13** and an output driver stage **14.** An input buffer **11** (e.g., inverter) is also provided for buffering a data input signal DIN. As illustrated, the input driver stage **12** includes an NMOS pull-down transistor NM1 and a pull-up resistor R1. The gate terminal of the NMOS pull-down transistor NM1 receives a complementary data input signal DINB generated by the input buffer **11.** The intermediate driver stage **13** includes an NMOS pull-down transistor NM2 and a pull-up resistor R2. The gate terminal of the NMOS pull-down transistor NM2 is electrically coupled to an output (e.g., drain terminal of NMOS transistor NM1) of the input driver stage **12.** The output driver stage **14** includes an NMOS pull-down transistor NM3 and a pull-up/termination resistor R3. The gate terminal of the NMOS pull-down transistor NM3 is electrically coupled to an output (e.g., drain terminal of NMOS transistor NM2) of the intermediate driver stage **13.** The value of the pull-up/termination resistor R3 is typically chosen to match a resistance of a load (not shown) being driven by the output DOUT of the output driver stage **14** and thereby inhibit signal reflection at the output DOUT. The resistance values of the pull-up resistors R1 and R2 are typically chosen at relatively small values (e.g., 50 or 75 ohms) so that the swing widths of the signals at the outputs of the input driver stage **12** and the intermediate driver stage **13** are less than rail-to-rail.

As will be understood by those skilled in the art, the swing width of the signal at the output of the input driver stage **12** will range from a maximum voltage of Vdd when the NMOS pull-down transistor NM1 is off to a minimum voltage of Vdd(R_{NM1}/(R1 + R_{NM1})) when the NMOS pull-down transistor NM1 is on. The value R_{NM1} designates an on-state resistance of the NMOS pull-down transistor NM1. Because the minimum voltage of the signal at the output of the input driver stage **12** may prevent the NMOS pull-down transistor NM2 from completely turning off, the swing width of the signal at the output of the intermediate driver stage **13** will range from a maximum voltage of less than Vdd to a minimum voltage of Vdd(R_{NM2}/(R2 + R_{NM2})) when the NMOS pull-down transistor NM2 is turned on fully. The value R_{NM2} designates an on-state resistance of the NMOS pull-down transistor NM2. The relatively small swing width of the signal at the output of the intermediate driver stage **13** translates to an even smaller swing width of the output signal DOUT.

FIG. 2 is an electrical schematic of a conventional output driver circuit **20** that generates a pair of differential output signals TXN and TXP in response to a pair of differential input signals DP and DN. This output driver circuit **20** includes first and second bias transistors NM13 and NM14, which are responsive to a bias signal Vb, and first and second input transistors NM11 and NM12, which have commonly connected source terminals. The first and second bias transistors NM13 and NM14 operate as current sources that establish first and second pull-down currents I1 and 12. The output driver circuit **20** also includes first and second load resistors R11 and R12, which are coupled to a pair of outputs OUT1 and OUT2. Based on this configuration of the output driver circuit **20,** the swing widths of the output signals TXN and TXP will be a function of the values of the load/termination resistors R11 and R12 (e.g., 50 or 75 ohms) and the values of the pull-down currents I1 and 12.

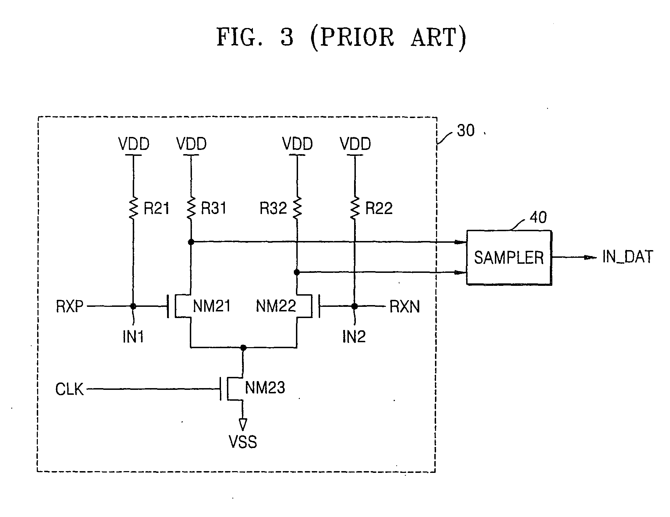

FIG. 3 is an electrical schematic of a conventional input circuit **30** and input signal sampler **40,** which generates an input signaIIN_DAT. As illustrated, the input circuit **30** includes a pair of termination resistors R21 and R22, a pair of load resistors R31 and R32 and NMOS transistors NM21, NM22 and NM23. The gate terminals of the NMOS transistors NM21 and NM22 receive a pair of differential input signals RXP and RXN at the inputs IN1 and IN2. The NMOS transistor NM23, which is responsive to a clock signal CLK, operates as an enable transistor that determines when the input circuit **30** is active. The signal swing widths of these input signals is influenced by the values of the termination resistors R21 and R22, which may have relatively small values (e.g., 50 or 75 ohms). The drain terminals of the NMOS transistors NM21 and NM22 develop a pair of differential signals, which are provided as inputs to the sampler **40.**

JP09008634 describes a device for varying an electrical output level for an integrated circuit.

Unfortunately, although the generation of signals having relatively small swing widths may increase the operating speeds of driver circuits, these small swing widths may complicate testing of integrated circuits at the wafer level if the swing widths are insufficient to be reliably detected by test equipment. Thus, notwithstanding the performance advantages provided by driver circuits having small swing widths, there continues to be a need for driver circuits that support small swing widths and also support reliable testing at the wafer level.

### Summary of the invention

An integrated circuit device according to embodiments of the invention includes an output driver responsive to an input signal and a swing width control signal (a/k/a test enable signal TE). The output driver is configured to generate an output signal having a first swing width when the swing width control signal designates a normal mode of operation and a second swing width greater than the first swing width when the swing width control signal designates a test mode of operation. The second swing width may be a rail-to-rail swing width (e.g., Vdd-to-Vss). The output driver includes a driver stage responsive to the input signal and a swing width adjusting circuit responsive to the input signal and the swing width control signal.

These embodiments may also include a multi-stage driver having an output electrically coupled to an input of the output driver. This multi-stage driver is configured to generate the input signal having a less than rail-to-rail swing width. A multi-stage bypass buffer is also provided. This bypass buffer has an output that is electrically coupled to the input of the output driver. The multi-stage bypass buffer is responsive to the swing width control signal and is configured to selectively increase the swing width of the input signal when the swing width control signal designates the test mode of operation. The output of the multi-stage bypass buffer may also be disposed in a high impedance state when the swing width control signal designates a normal mode of operation.

### Brief Description of the Drawings

FIG. 1 is an electrical schematic of a conventional output driver circuit having multiple stages.
FIG. 2 is an electrical schematic of a conventional output driver circuit that generates a pair of differential output signals.
FIG. 3 is an electrical schematic of a conventional input circuit and input signal sampler.
FIG. 4 is an electrical schematic of an output driver having multiple stages, according to embodiments of the present invention.
FIG. 5 is an electrical schematic of an output driver having an output driver stage configured according to embodiments of the present invention.
   **(Please confirm that FIG. 5 is NOT a prior art driver of conventional** design)
FIG. 6 is a graph showing signal swing widths versus termination resistance for the output driver of FIG. 5.
FIG. 7 is an electrical schematic of an output driver and bypass circuit according to additional embodiments of the present invention.
FIG. 8 is an electrical schematic of the bypass circuit of FIG. 7.
FIG. 9 is an electrical schematic of a differential output driver having multiple stages, according to embodiments of the present invention.
FIG. 10 is an electrical schematic of an embodiment of the differential output driver stage of FIG. 9.
FIG. 11 is an electrical schematic of an embodiment of the differential output driver stage of FIG. 9.
FIG. 12 is an electrical schematic of an embodiment of the differential output driver stage of FIG. 9.
FIG. 13 is an electrical schematic of an embodiment of the differential output driver stage of FIG. 9.
FIG. 14 is an electrical schematic of an embodiment of the differential output driver stage of FIG. 9.
FIG. 15 is an electrical schematic of a differential output driver stage that may be used as a comparative example relative to the output driver stages of FIGS. 10-14. **(Please confirm that FIG. 15 is not a prior art driver stage of conventional design)**
FIG. 16 is an electrical schematic of a differential output driver having multiple stages and a differential bypass circuit, according to embodiments of the present invention.
FIG. 17 is an electrical schematic of the differential bypass circuit of FIG. 16.
FIG. 18 is an electrical schematic of a differential input circuit and input signal sampler, according to embodiments of the present invention.

### Description of Preferred Embodiments

The present invention now will be described more fully herein with reference to the accompanying drawings, in which preferred embodiments of the invention are shown. This invention may, however, be embodied in many different forms and should not be construed as being limited to the embodiments set forth herein; rather, these embodiments are provided so that this disclosure will be thorough and complete, and will fully convey the scope of the invention to those skilled in the art. Like reference numerals refer to like elements throughout and signal lines and signals thereon may be referred to by the same reference characters. Signals may also be synchronized and/or undergo minor boolean operations (e.g., inversion) without being considered different signals. The suffix B (or prefix symbol "/") to a signal name may also denote a complementary data or information signal or an active low control signal, for example.

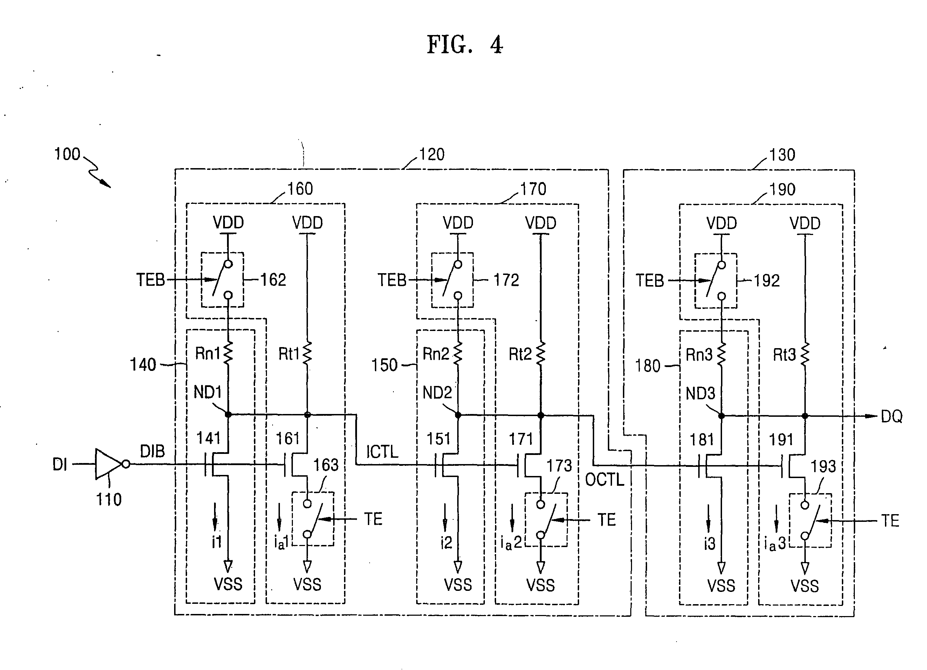

FIG. 4 is an electrical schematic of a multi-stage output driver circuit **100** according to embodiments of the present invention. This output driver circuit **100** includes a control driver stage **120** and an output driver stage **130.** The control driver stage **120** includes an input driver stage and an intermediate driver stage. The input driver stage includes a driver **140** and a swing width adjusting circuit **160** and the intermediate driver stage includes a driver **150** and a swing width adjusting circuit **170.** The output driver stage **130** includes a driver **180** and a swing width adjusting circuit **190.** A buffer **110** (e.g., inverter) may also be provided for buffering a data input signal DI. The signal generated at an output DIB of the buffer **110** is typically a full swing signal (i.e., swings between Vdd and Vss when switching high and low).

The driver **140** is illustrated as including an NMOS pull-down transistor **141** having a gate terminal connected to the output DIB of the buffer **110** and a source terminal connected to a ground reference line (e.g., Vss = 0 Volts). A drain terminal of the NMOS pull-down transistor **141** is connected to an output node ND1 of the driver **140** and a first terminal of a normal mode resistor Rn1. The resistance of the normal mode resistor Rn1 is typically relatively small (e.g., 50 ohms). The swing width adjusting circuit **160** includes an NMOS pull-down transistor **161** having a drain terminal connected to the output node ND1 and a first terminal of a test mode resistor Rt1, which typically has a relatively large value (e.g., 1 K ohms). A second terminal of the test mode resistor Rt1 is connected to a power supply line (e.g., Vdd). The swing width adjusting circuit **160** also includes a first switching element **162** and a second switching element **163,** connected as illustrated. The first switching element **162** is responsive to a complementary test enable signal TEB, which may be treated herein as an inverted swing width control signal. The second switching element **163** is responsive to a true test enable signal TE, which may be treated herein as a true swing width control signal.

When the true test enable signal TE is inactive (i.e., TE=0 and TEB=1), the first switching element **162** will be closed and the second switching element **163** will be open. The closure of the first switching element **162** will cause the normal mode resistor Rn1 and the test mode resistor Rt1 to be in parallel with each other. When this parallel relationship is present, the effective resistance between the output node ND1 and the power supply line Vdd will be approximately equal to the resistance of the normal mode resistor Rn1 for the case where Rn1 << Rt1. Accordingly, setting the true test enable signal TE to an inactive level during normal mode operation will cause the control signal ICTL at the output node ND1 to have a smaller swing width relative to the signal DIB at the output of the buffer **110.** In particular, when the signal DIB switches low-to-high (e.g., Vss-to-Vdd), the NMOS pull-down transistor **141** will turn on fully and sink a pull-down current of i1 through the parallel combination of the normal and test mode resistors Rn1 and Rt1. In response, the output node ND1 will be pulled low to a value equal to Vdd(R₁₄₁/((Rn1||Rt1) + R₁₄₁)), where the resistance value R₁₄₁ designates a fully on-state resistance of the NMOS pull-down transistor **141** and the value (Rn1||Rt1) represents the combined parallel resistance of the normal and test mode resistors Rn1 and Rt1. In contrast, when the signal DIB switches high-to-low (e.g., Vdd-to-Vss), the NMOS pull-down transistor **141** will turn off fully and the output node ND1 will be pulled high to a value equal to about Vdd. The swing width of the control signal ICTL may be about 1.2 Volts for the case where Vdd equals 1.8 Volts and Vdd(R₁₄₁/((Rn1||Rt1) + R₁₄₁)) equals about 0.6 Volts.

However, during a test mode of operation, the true test enable signal TE will be active and the complementary test enable signal TEB will be inactive (i.e., TE=1 and TEB=0). When this occurs, the first switching element **162** will be open and the second switching element **163** will be closed and the swing width of the control signal ICTL will increase to about 1.8 Volts (i.e., full rail-to-rail) for the case where Vdd equals 1.8 Volts. In particular, closing the second switching element **163** will cause the parallel pull-down resistance of the NMOS pull-down transistors **141** and **161** to be very small when the signal DIB switches low-to-high and a combined sink current of i1+ia1 is pulled through the relatively large test mode resistor Rt1. Using conventional voltage division rules, the control signal ICTL will switch to a low level of about Vss when the signal DIB switches low-to-high and switch to a high level of about Vdd when the signal DIB switches high-to-low and the NMOS pull-down transistors **141** and **161** are turned off. Accordingly, setting the true test enable signal TE to an active level and the complementary test enable signal TEB to an inactive level during a test mode of operation will cause the swing width adjusting circuit **160** to increase the swing width of the control signal ICTL to a full rail-to-rail level (e.g., increase the swing width from about 1.2 Volts during normal mode to about 1.8 Volts during test mode for the case where Vdd=1.8 Volts).

The above-description of the operation of the input driver stage also applies to the intermediate driver stage, which includes the driver **150** and swing width adjusting circuit **170.** The driver **150** is illustrated as including an NMOS pull-down transistor **151** having a gate terminal connected to the output ICTL of the input driver stage and a source terminal connected to the ground reference line (e.g., Vss). A drain terminal of the NMOS pull-down transistor **151** is connected to an output node ND2 of the driver **150** and a first terminal of a normal mode resistor Rn2. The resistance of the normal mode resistor Rn2 is typically relatively small (e.g., 50 ohms). The swing width adjusting circuit **170** includes an NMOS pull-down transistor **171** having a drain terminal connected to the output node ND2 and a first terminal of a test mode resistor Rt2, which typically has a relatively large value (e.g., 1 K ohms). A second terminal of the test mode resistor Rt2 is connected to the power supply line (e.g., Vdd). The swing width adjusting circuit **170** also includes a first switching element **172** and a second switching element **173,** connected as illustrated. The first switching element **172** is responsive to the complementary test enable signal TEB. The second switching element **173** is responsive to the true test enable signal TE.

When the true test enable signal TE is inactive (i.e., TE=0 and TEB=1), the first switching element **172** will be closed and the second switching element **173** will be open. The closure of the first switching element **172** will cause the normal mode resistor Rn2 and the test mode resistor Rt2 to be in parallel with each other. When this parallel relationship is present, the effective resistance between the output node ND2 and the power supply line Vdd will be approximately equal to the resistance of the normal mode resistor Rn2 for the case where Rn2 << Rt2. Accordingly, setting the true test enable signal TE to an inactive level during normal mode operation will cause the control signal OCTL at the output node ND2 to have a smaller swing width relative to the control signal ICTL at the output of the input driver stage. In particular, when the control signal ICTL switches low-to-high, the NMOS pull-down transistor **151** will turn on fully and sink a pull-down current of i2 through the parallel combination of the normal and test mode resistors Rn2 and Rt2. In response, the output node ND2 will be pulled low to a value equal to Vdd(R₁₅₁/((Rn2∥Rt2) + R₁₅₁)), where the resistance value R₁₅₁ designates a fully on-state resistance of the NMOS pull-down transistor **151** and the value (Rn2∥Rt2) represents the combined parallel resistance of the normal and test mode resistors Rn2 and Rt2. In contrast, when the control signal ICTL switches low to a level equal to about Vdd(R₁₄₁/((Rn1∥Rt1) + R₁₄₁)), the NMOS pull-down transistor **151** will turn off partially and the output node ND2 will be pulled high to a value less than Vdd. Accordingly, during a normal mode of operation, the swing width of the control signal OCTL at the output of the intermediate driver stage will be less than the swing width of the control signal ICTL at the output of the input driver stage.

However, during a test mode of operation, the true test enable signal TE will be active and the complementary test enable signal TEB will be inactive (i.e., TE=1 and TEB=0). When this occurs, the first switching element **172** will be open and the second switching element **173** will be closed and the swing width of the control signal OCTL (and control signal ICTL) will increase to about 1.8 Volts (i.e., full rail-to-rail) for the case where Vdd equals 1.8 Volts. In particular, dosing the second switching element **173** will cause the parallel pull-down resistance of the NMOS pull-down transistors **151** and **171** to be very small when the control signal ICTL switches low-to-high and a combined sink current of i2+ia2 is pulled through the relatively large test mode resistor Rt2. Using conventional voltage division rules, the control signal OCTL will switch to a low level of about Vss when the control signal ICTL switches low-to-high or switch to a high level of about Vdd when the control signal ICTL switches high-to-low and the NMOS pull-down transistors **151** and **171** are turned off.

The control signal OCTL is provided as an input to the driver **180** within the output driver stage **130.** This driver **180** includes a NMOS pull-down transistor **181** having a source terminal connected to the ground reference line Vss and a drain terminal connected to an output node ND3, the output DQ of the multi-stage output driver circuit **100** and a first terminal of a normal mode termination resistor Rn3. The swing width adjusting circuit **190** includes a NMOS pull-down transistor **191** having a drain terminal connected to the output node ND3 and a first terminal of a test termination resistor Rt3, which typically has a relatively large value (e.g., 1 K ohms). A second terminal of the test mode termination resistor Rt3 is connected to the power supply line (e.g., Vdd). The swing width adjusting circuit **190** also includes a first switching element **192** and a second switching element **193,** connected as illustrated. When the true test enable signal TE is inactive (i.e., TE=0 and TEB=1), the resistors Rn3 and Rt3 will operate in parallel and the driver **180** will generate an output signal DQ having a smaller swing width relative to the swing width of the control signal OCTL. However, when the true test enable signal TE is active (i.e., TE=1 and TEB=0), the control signals ICTL and OCTL and the output signal DQ will all have full swing widths similar to the signals DI and DIB and the sink currents i3 and ia3 will be pulled through the test termination resistor Rt3.

Accordingly, FIG. 4 illustrates an output driver **130** responsive to an input signal (e.g., OCTL) and a swing width control signal, which is described herein as a test enable signal TE. The output driver **130** is configured to generate an output signal DQ having a first swing width when the swing width control signal TE designates a normal mode of operation and a second swing width greater than the first swing width when the swing width control signal TE designates a test mode of operation. The second swing width may be a rail-to-rail swing width (e.g., Vdd-to-Vss). The output driver may include a driver stage **180** responsive to the input signal and a swing width adjusting circuit **190** responsive to the input signal (OCTL) and the swing width control signal TE.

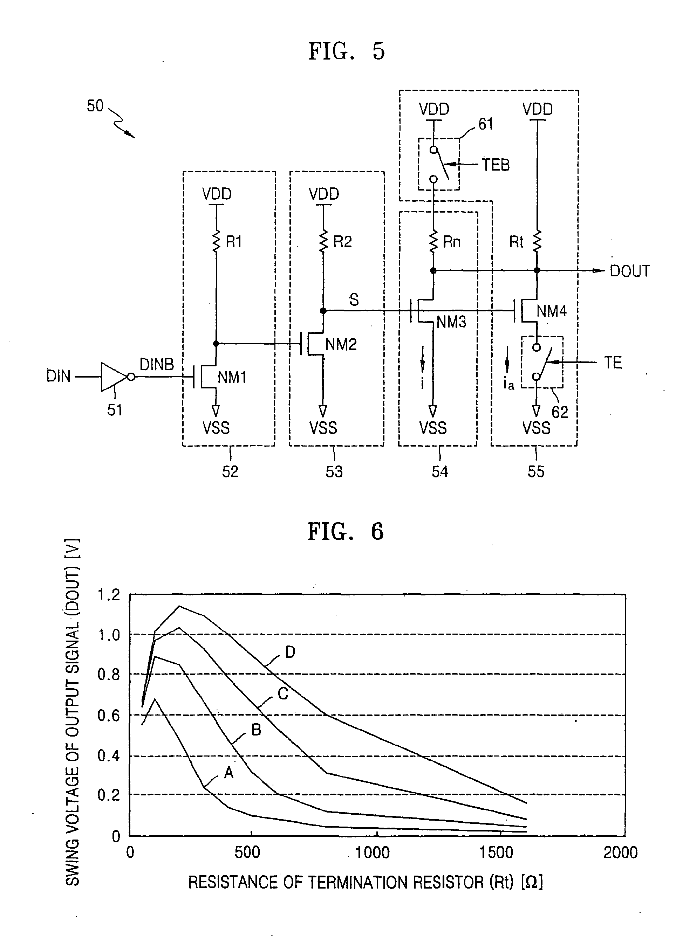

In contrast to the multi-stage output driver circuit **100** of FIG. 4, the multi-stage output driver circuit **50** of FIG. 5 includes only one swing width adjusting circuit **55** that is responsive to a test enable signal during test mode operation. In particular, the output driver circuit **50** of FIG. 5 includes a buffer **51** that generates a complementary data input signal DINB in response to a data input signal DIN. A first stage of the output driver circuit **50** includes a first driver **52** containing an NMOS pull-down transistor NM1 and a pull-up resistor R1, connected as illustrated. A signal developed at a drain terminal of the NMOS pull-down transistor NM1 is provided as an input to a second driver **53.** This second driver **53** contains an NMOS pull-down transistor NM2 and a pull-up resistor R2, connected as illustrated. A signal S developed at a drain terminal of the NMOS pull-down transistor NM2 is provided as an input to a third driver **54** and swing width adjusting circuit **55.** As will be understood by those skilled in the art, the signal S will have a smaller swing width relative to the data input signal DIN, which may switch at full CMOS levels (e.g., full rail-to-rail).

As illustrated, the third driver **54** includes an NMOS pull-down transistor NM3 and a normal resistor Rn and the swing width adjusting circuit **55** includes an NMOS pull-down transistor NM4, a test termination resistor Rt, a first switching element **61** and a second switching element **62.** The first and second switching elements **61** and **62** are responsive to the true and complementary test enable signals TE and TEB, respectively. As described above, setting the test enable signal TE to an active level (i.e., TE=1 and TEB=0) will operate to increase the swing width of the data output signal DOUT relative to the swing width of the signal S provided as an input to the third driver **54.** However, because the signal S does not have a full swing width when the test enable signal TE is active, the data output signal DOUT cannot achieve a full swing width even when a swing width adjustment provided by the swing width adjusting circuit 55 is taken into account.

This failure of the data output signal DOUT to achieve a full swing width is illustrated by the graph of FIG. 6. In particular, FIG. 6 is a graph containing four curves A, B, C and D. The y-axis of the graph specifies the swing width of the data output signal DOUT and the x-axis of the graph specifies the resistance value of the test termination resistor Rt within the swing width adjusting circuit **55.** The curve A corresponds shows the swing width of the data output signal DOUT as a function of the resistance of the test termination resistor Rt, for the case where a resistor R2 within the driver **53** has a first value. The curve B corresponds shows the swing width of the data output signal DOUT as a function of the resistance of the test termination resistor Rt, for the case where a resistor R2 within the driver **53** has a second value greater than the first value. The curve C corresponds shows the swing width of the data output signal DOUT as a function of the resistance of the test termination resistor Rt, for the case where a resistor R2 within the driver **53** has a third value greater than the second value. The curve D corresponds shows the swing width of the data output signal DOUT as a function of the resistance of the test termination resistor Rt, for the case where a resistor R2 within the driver **53** has a fourth value greater than the third value.

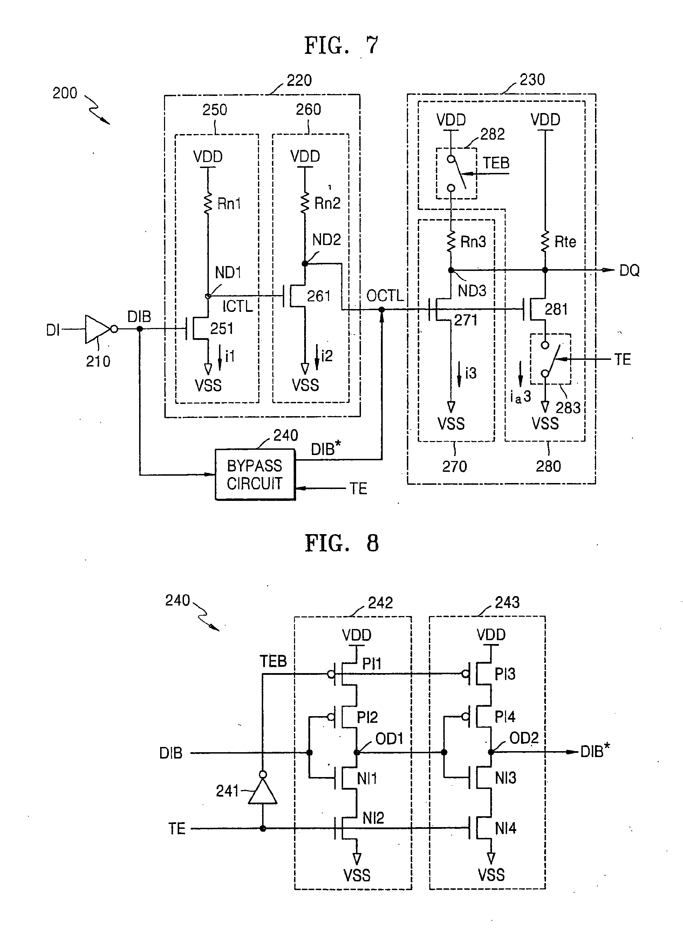

To address the limitations described above with respect to the multi-stage output driver circuit **50** of FIG. 5, a multi-stage output driver **200** according to another embodiment of the present invention includes a bypass circuit **240,** which operates to increase a swing width of a signal (e.g., OCTL) provided as an input to an output driver stage **230** during test mode operation. As illustrated by FIG. 7, the output driver **200** includes a buffer **210** (optional), a control driver stage **220,** an output driver stage **230** and a bypass circuit **240.** The control driver stage **220** includes an input driver stage **250** and an intermediate driver stage **260.** The output driver stage **230** includes an output driver **270** and a swing width adjusting circuit **280.**

The buffer **210** generates a complementary data input signal DIB in response to a true data input signal DI. The complementary data input signal DIB may have a full swing width established at CMOS levels. The input driver stage **250** includes an NMOS pull-down transistor **251** and a normal mode resistor Rn1, connected as illustrated. An output node ND1 of the input driver stage **250** generates a control signal ICTL, which is provided as an input to the intermediate driver stage **260.** When the NMOS pull-down transistor **251** is turned on, a pull-down current i1 will pass through the normal mode resistor Rn1. The intermediate driver stage **260** includes an NMOS pull-down transistor **261** and a normal mode resistor Rn2, connected as illustrated. An output node ND2 of the intermediate driver stage **260** generates a control signal OCTL, which is provided as an input to the output driver **270.** When the NMOS pull-down transistor **261** is turned on, a pull-down current i2 will pass through the normal mode resistor Rn2. This control signal OCTL has relatively small swing width properties similar to the signal S illustrated in FIG. 5 during normal mode operation. However, during test mode operation, the swing width of the control signal OCTL is increased to a full rail-to-rail value by the bypass circuit **240.**

As illustrated by FIG. 8, this bypass circuit **240** includes an inverter **241,** a first bypass stage **242** and a second bypass stage **243.** The first and second bypass stages **242** and **243** provide a double buffering of the complementary data input signal DIB generated by the buffer **210** when the test enable signal TE is active (i.e., TE=1 and TEB=0). Alternatively, the first and second bypass stages **242** and **243** are disabled when the test enable signal TE is inactive. When disabled, the second bypass stage **243** generates a high impedance output (i.e., DIB*=high Z). The first bypass stage **242** includes a totem pole arrangement of two PMOS transistors P11 and P12 and two NMOS transistors N11 and N12. When the test enable signal TE is active, the first bypass stage **242** operates as a CMOS inverter, which means an output node OD1 of the first bypass stage **242** switches rail-to-rail in response to the complementary data input signal DIB. Similarly, the second bypass stage **243** includes a totem pole arrangement of two PMOS transistors P13 and P14 and two NMOS transistors N13 and N14. When the test enable signal TE is active, the second bypass stage **243** operates as a CMOS inverter, which means a double buffered complementary data input signal DIB* at node OD2 switches rail-to-rail. Moreover, because the total delay provided by the first and second bypass stages **242** and **243** is about equal to the total delay provided by the input and intermediate driver stages **250** and **260** during test mode operation, the control signal OCTL will be pulled rail-to-rail by the double buffered complementary data input signal DIB*.

Accordingly, during test mode operation when the test enable TE signal is active, the swing width of the control signal OCTL will increase to a full rail-to-rail level. Moreover, the swing width adjusting circuit **280** will be active to support a full swing width of the output signal DQ. In particular, increasing the swing width of the control signal OCTL will cause the NMOS pull-down transistor **271** to turn on fully when the control signal OCTL switches low-to-high or turn off fully when the control signal OCTL switches high-to-low. Setting the test enable signal to an active level will also cause the switch element **283** to close and the switch element **281** to open and thereby block current conduction through the normal resistor Rn3. When the NMOS pull-down transistors **271** and **281** are turned on fully in response to a low-to-high transition of the control signal OCTL, the currents i3 and ia3 will be pulled through the test termination resistor Rte and the node ND3 and output terminal DQ will be driven to a ground reference voltage Vss. Alternatively, when the NMOS pull-down transistors **271** and **281** are turned off fully in response to a high-to-low transition of the control signal OCTL, the node ND3 and the output terminal DQ will be pulled high to a power supply voltage Vdd. In this manner, the bypass circuit **240** of FIGS. 7-8 may be provided as a substitute for the swing width adjusting circuits **160** and **170** of FIG. 4.

Accordingly, FIGS. 7-8 illustrate an output driver **230** responsive to an input signal (OCTL) and a swing width control signal TE. The output driver **230** is configured to generate an output signal DQ having a first swing width when the swing width control signal designates a normal mode of operation and a second swing width greater than the first swing width when the swing width control signal designates a test mode of operation. A multi-stage driver **220** is also provided. The multi-stage driver **220** has an output electrically coupled to an input of the output driver **230.** The multi-stage driver **220** is configured to generate the input signal OCTL having a less than rail-to-rail swing width. A multi-stage bypass buffer **240** is also provided. The multi-stage bypass buffer **240** is electrically coupled,to the input of the output driver **230** and is responsive to the swing width control signal TE. The multi-stage bypass buffer **220** is configured to selectively increase the swing width of the input signal OCTL when the swing width control signal designates the test mode of operation. The output driver **230** includes a driver stage **270** responsive to the input signal OCTL and a swing width adjusting circuit **280** responsive to the input signal OCTL and the swing width control signal TE. The swing width adjusting circuit **280** includes at least one switching element **283** responsive to the swing width control signal TE.

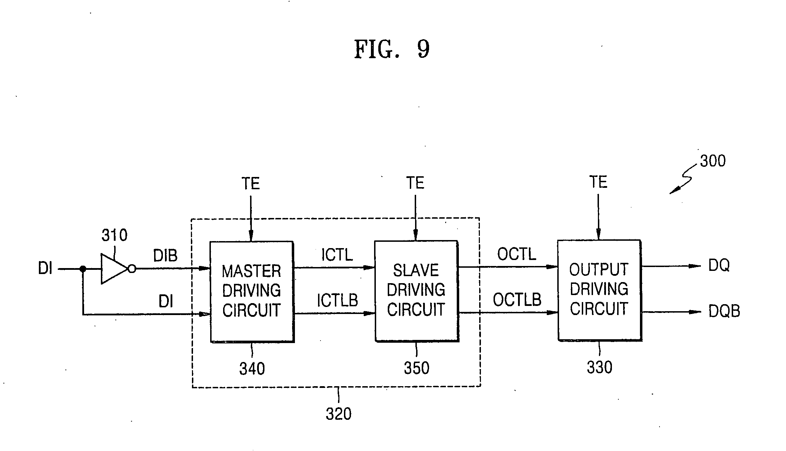

Referring now to FIG. 9, a multi-stage output driver **300** according to additional embodiments of the invention is similar to the output driver **100** of FIG. 4, however, each of the stages of the output driver **300** processes a respective pair of differential signals instead of a single signal. These differential signals are illustrated as (DI, DIB), (ICTL, ICTLB), (OCTL, OCTLB) and (DQ, DQB). In particular, the multi-stage output driver **300** includes a buffer **310** (optional), a control driver stage **320** and an output driver stage **330.** The control driver stage **320** includes an input driver stage **340,** shown as a master driver, and an intermediate driver stage **350,** shown as a slave driver. The master driver **340** generates a pair of control signals ICTL and ICTLB in response to a pair of data input signals DI and DIB. The slave driver **350** generates a pair of control signals OCTL and OCTLB in response to the pair of control signals ICTL and ICTLB. The output driver stage **330** generates a pair of data output signals DQ and DQB in response to the control signals OCTL and OCTLB. The master driver **340,** the slave driver **350** and the output driver stage **330** are all responsive to a test enable signal TE and may be configured as equivalent circuits. When the test enable signal TE is set to an active level during a test mode of operation, the signals ICTL, ICTLB, OCTL, OCTLB, DQ and DQB will be switched rail-to-rail and thereby have full swing widths to support wafer level and other types of testing. In contrast, when the test enable signal TE is set to an inactive level during normal mode operation, the signals ICTL, ICTLB, OCTL, OCTLB, DQ and DQB will have less than full swing widths, which supports high speed switching.

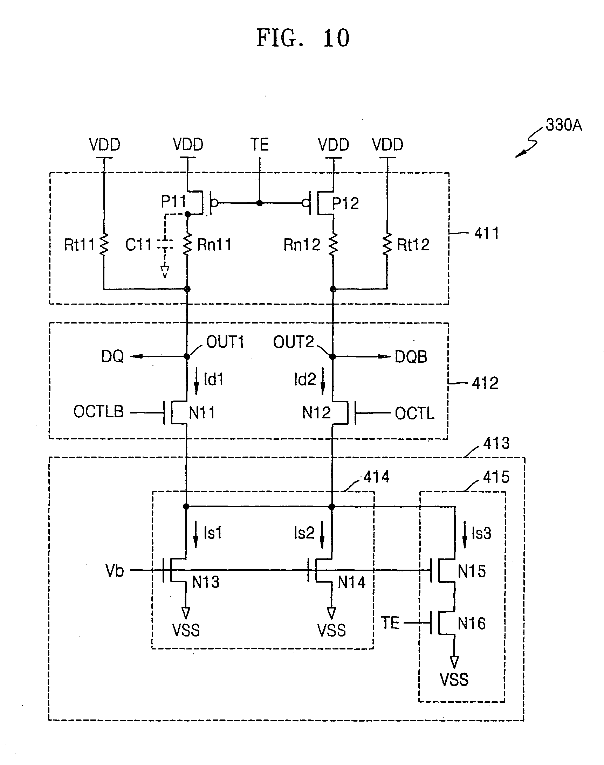

FIGS. 10-14 illustrate five alternative embodiments of the output driver stage **330** (and equivalent master and slave drivers) of FIG. 9. In particular, FIG. 10 is an electrical schematic of an output driver **330A** containing a load circuit **411,** a comparing circuit **412** and a current source circuit **413** containing a primary current source **414** and a secondary current source **415.** The load circuit **411** is illustrated as including a pair of termination resistors Rt11 and Rt12, which may have large resistances of about 1 K ohms, and a pair of normal mode resistors Rn11 and Rn12, which may have relatively small resistances of about 50 ohms, for example. PMOS pull-up transistors P11 and P12 are also provided. These pull-up transistors P11 and P12 are responsive to a test enable signal TE. When the test enable signal TE is set to an active level (i.e., TE=1), the PMOS pull-up transistors P11 and P12 are turned off and the normal mode resistors Rn11 and Rn12 are blocked from influencing a pull-up impedance of the load circuit **411.** However, when the test enable signal TE is set to an inactive level (i.e., TE=0), the PMOS pull-up transistors P11 and P12 are turned on. When this occurs, the combined parallel resistance of the normal mode resistor Rn11 and termination resistor Rt11 is approximately equal to the resistance of the normal mode resistor Rn11. Similarly, the combined parallel resistance of the normal mode resistor Rn12 and termination resistor Rt12 is approximately equal to the resistance of the normal mode resistor Rn12.

The comparing circuit **412** is illustrated as including NMOS input transistors N11 and N12 having commonly connected source terminals. These input transistors N11 and N12 are responsive to the control signals OCTL and OCTLB. The drain terminals of the NMOS input transistors N11 and N12 are connected to the output nodes OUT1 and OUT2, which produce the pair of output signals DQ and DQB. As will be understood by those skilled in the art, when the control signal OCTL is set high to Vdd and the control signal OCTLB is set low to Vss, the current Id2 will be pulled down from the right side of the load circuit **411.** Alternatively, when the control signal OCTLB is set high to Vdd and the control signal OCTL is set low to Vss, the current Id1 will be pulled down from the left side of the load circuit **411.**

The primary current source **414** includes a pair of NMOS pull-down transistors N13 and N14, which are responsive to a bias voltage Vb. The sinking currents Is1 and Is2 are provided through the pull-down transistors N13 and N14. The secondary current source **415** includes NMOS transistors N15 and N16. NMOS transistor N15 is responsive to the bias signal Vb and NMOS transistor N16 is responsive to the test enable signal TE. Based on this configuration of the secondary current source **415,** the pull-down current Is3 will be added to the sinking currents Is1 and Is2 only during the test mode of operation when the test enable signal TE is active.

Accordingly, the output driver **330A** is configured so that the output signals DQ and DQB will have relatively small swing widths when the control signals OCTL and OCTLB, which have somewhat larger swing widths, are switching during normal mode operation. During this normal mode of operation, the output driver **330A** operates as a differential amplifier having input transistors N11 and N12, a primary current source **414** which is commonly connected to the source terminals of the input transistors N11 and N12 and parallel load impedances ((Rn11∥Rt11) and (Rn12||Rt12)), which are approximately equal to the values of the normal mode resistors Rn11 and Rn12, respectively, for the case where Rn11<<Rt11 and Rn12<<Rt12. In contrast, during the test mode of operation when the test enable signal TE is active, the swing widths of the control signals OCTL and OCTLB will be rail-to-rail signals and the normal mode resistors Rn11 and Rn12 will be disconnected from the pull-up paths within the load circuit **411** because the PMOS pull-up transistors P11 and P12 will be turned off. In addition, the secondary current source **415** will be active to increase the total pull-down current provided by the current source circuit **413.** This additional current supports an increase in the swing widths of the output signals DQ and DQB when the NMOS input transistors N11 and N12 are alternatively turned on and off in response to the control signals OCTL and OCTLB.

The switching speed of the output driver **330A** of FIG. 10 during the normal mode of operation is influenced by the parasitic gate-to-drain capacitances of the PMOS transistors P11 and P12. The capacitor C11, shown with dotted lines, reflects the parasitic capacitance of the PMOS transistor P11 and the PMOS transistor P12 has a similar parasitic capacitance (not shown). Maintaining these parasitic capacitance values at relatively low levels can improve the switching speed of the output driver 330A by reducing the RC time constant associated with the RC network defined by resistors Rt11, Rn11 and PMOS transistor P11 and the RC network defined by resistors Rt12, Rn12 and PMOS transistor P12.

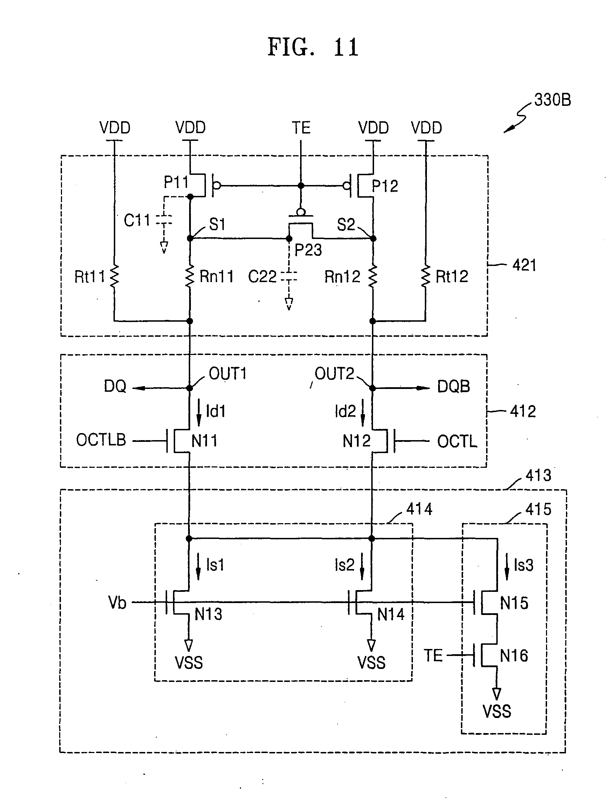

FIG. 11 illustrates an output driver **330B** according to another embodiment of the present invention. This output driver **330B** is similar to the output driver **330A** of FIG. 10, however, a modified load circuit **421** is provided. This modified load circuit **421** includes an additional PMOS transistor P23 having source and drain terminals connected to nodes S1 and S2. The parasitic capacitance associated with a drain terminal of the PMOS transistor P23 is illustrated as capacitor C22, which is shown with dotted lines. Although not shown, a source terminal of the PMOS transistor P23 and a drain terminal of the PMOS transistor P12 also have parasitic capacitances. When the test enable signal TE is set to an inactive level during a normal mode of operation, which may include high speed switching of the output driver **330B,** the nodes S1 and S2 are electrically shorted together and to the power supply lines Vdd. When this occurs, the resistors Rt11, Rt12, Rn11 and Rn12 and the parasitic capacitors can be treated as a connected RC load network that supports higher speed switching relative to the load network within the load circuit **411** of FIG. 10. However, during a test mode of operation when the test enable signal TE is active (i.e., TE=1), the RC load network in the load circuit **421** will provide somewhat higher parasitic capacitance (because of the addition of the MOS transistor P23) and somewhat slower switching speed characteristics relative to the load network within the load circuit **411** of FIG. 10.

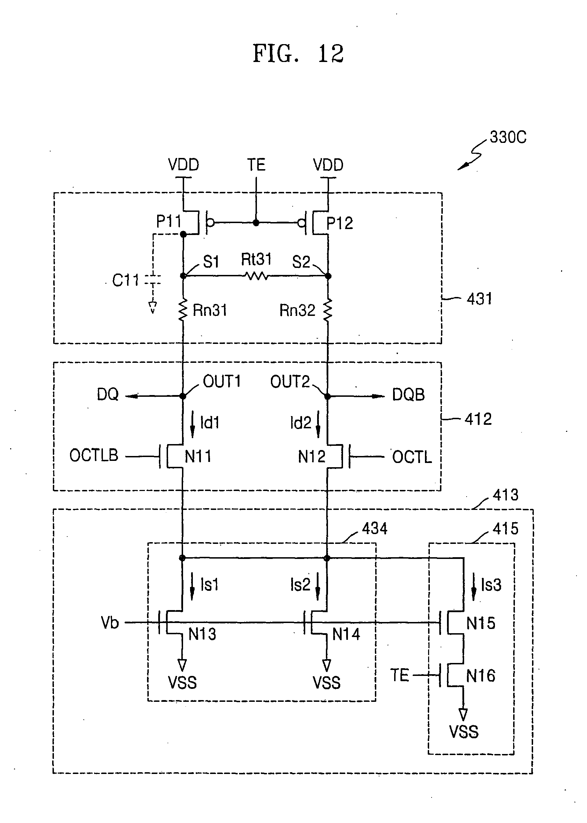

FIG. 12 illustrates an output driver **330C** according to another embodiment of the present invention. This output driver **330C** is similar to the output driver **330A** of FIG. 10, however, a modified load circuit **431** is provided. This modified load circuit **431** includes an additional test mode resistor Rt31 connected to nodes S1 and S2, but is missing the termination resistors Rt11 and Rt12 shown in FIG. 10. During a normal mode of operation when the test enable signal TE is inactive, the load circuit **431** is active to connect the normal resistors Rn31 and Rn32 to the power supply line Vdd and equilibrate the voltages at nodes S1 and S2 so that relatively little current passes through the test mode resistor Rt31. Alternatively, during a test mode of operation when the test enable signal TE is active, the PMOS transistors P11 and P12 are turned off and a power supply voltage Vdd is applied to the load circuit **431** by an external test circuit connected to the output nodes OUT1 and OUT2.

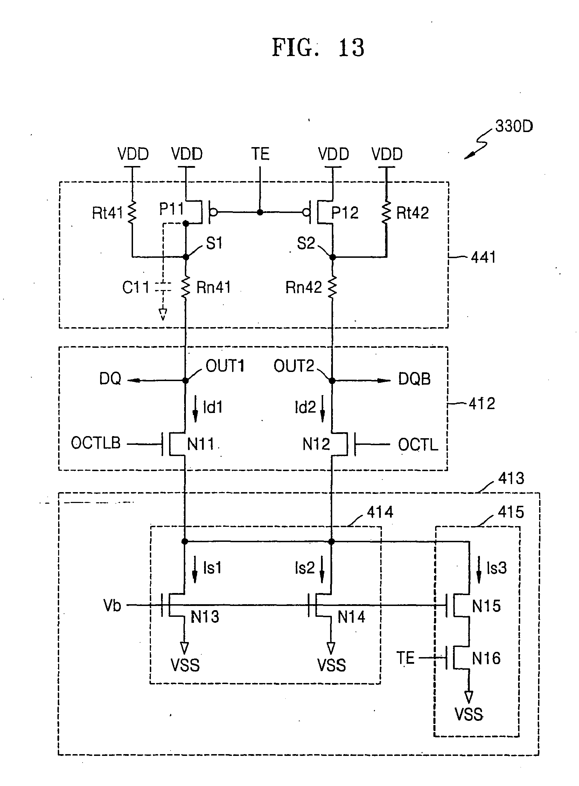

FIG. 13 illustrates an output driver **330D** according to another embodiment of the present invention. This output driver **330D** is similar to the output driver **330A** of FIG. 10, however, the termination resistors Rt41 and Rt42 in the load circuit **441** are connected to nodes S1 and S2 instead of the output nodes OUT1 and OUT2. When the test enable signal TE is active, the PMOS transistors P11 and P12 are turned off. When this occurs, the series combination of the normal resistor Rn41 and termination resistor Rt41 is provided between the output node OUT1 and the power supply line Vdd and the series combination of the normal resistor Rn42 and termination resistor Rt42 is provided between the output node OUT2 and the power supply line Vdd. In the event the series combination of the normal resistor Rn41 and termination resistor Rt41 is greater than the termination resistor Rt11 of FIG. 10, the swing width of the output signals DQ and DQB may be greater in the driver **330D** of FIG. 13 relative to the driver **330A** of FIG. 10.

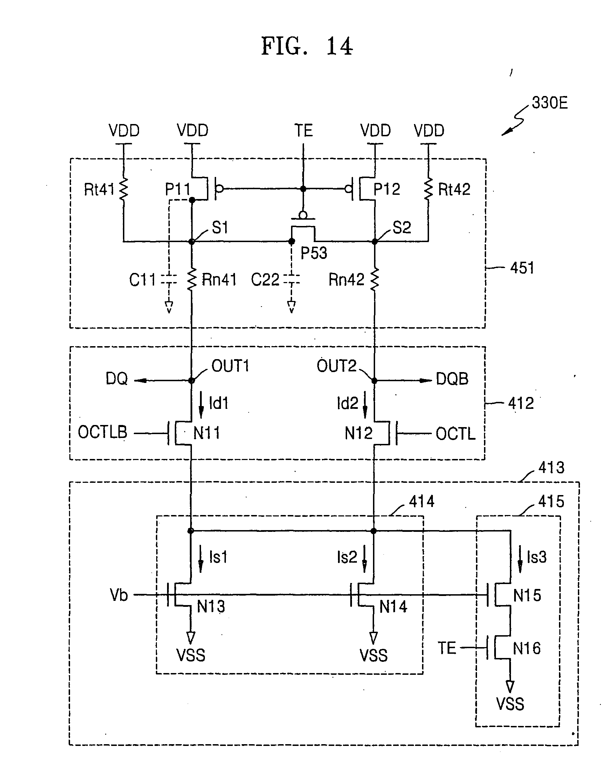

FIG. 14 illustrates an output driver **330E** according to another embodiment of the present invention. This output driver **330E** is similar to the output driver **330C** of FIG. 11, however, the load circuit **451** includes a PMOS equalization transistor P53, which is responsive to the test enable signal TE. During a normal mode of operation, when the test enable signal TE is inactive (i.e., TE=0), the nodes S1 and S2 will be shorted together by PMOS transistor P53 and pulled high to the power supply voltage by PMOS transistors P11 and P12. The PMOS equalization transistor P53 will add some additional parasitic capacitance (e.g., C52) to the nodes S1 and S2, but this additional capacitance may be offset by a lower overall RC loading on the output nodes OUT1 and OUT2.

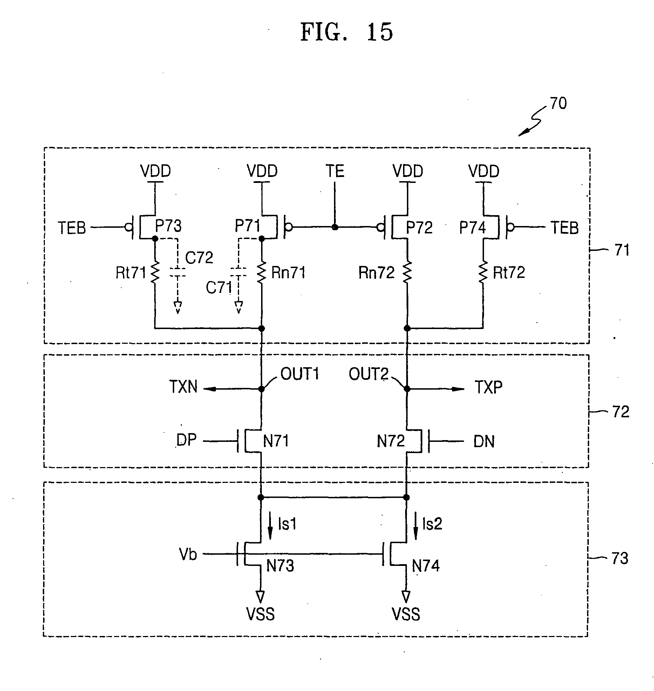

FIG. 15 is an electrical schematic of a differential output driver stage **70** that may be used as a comparative example relative to the output driver stages of FIGS. 10-14. This driver stage **70** includes a load circuit **71,** a comparing circuit **72** and a current source **73.** The current source **73** includes NMOS transistors N73 and N74, which are responsive to a bias voltage and sink currents Is1 and Is2, respectively, from the comparing circuit **72.** The comparing circuit **72** includes input transistors N71 and N72, which are responsive to a pair of differential input signals DP and DN. The drain terminals of the NMOS transistors N71 and N72 are connected to the output nodes OUT1 and OUT2, which produce a pair of differential output signals TXP and TXN. The load circuit 71 is illustrated as including a pair of termination resistors Rt71 and Rt72, a pair of normal mode resistors Rn71 and Rn72 and four PMOS pull-up transistors P71-P74, connected as illustrated. When the test enable signal TE is active during a test mode of operation, the PMOS transistors P73 and P74 are turned on and the PMOS transistors P71 and P72 are turned off. During this test mode, the swing widths of the output signals TXP and TXN will be increased and the relatively large resistors Rt71 and Rt72 (e.g., 1 K ohm resistors) will be active in the pull-up paths of the load circuit **71.** Alternatively, when the test enable signal TE is inactive during a normal mode of operation, the PMOS transistors P71 and P72 are turned on and the PMOS transistors P73 and P74 are turned off. However, if the parasitic capacitances provided by the PMOS transistors P71-P74 are significant, the maximum speed of operation of the driver stage **70** during the normal mode of operation may be limited. These parasitic capacitances are illustrated by C71 and C72 for PMOS transistors P71 and P73. The other PMOS transistors P72 and P74 have similar parasitic capacitances (not shown).

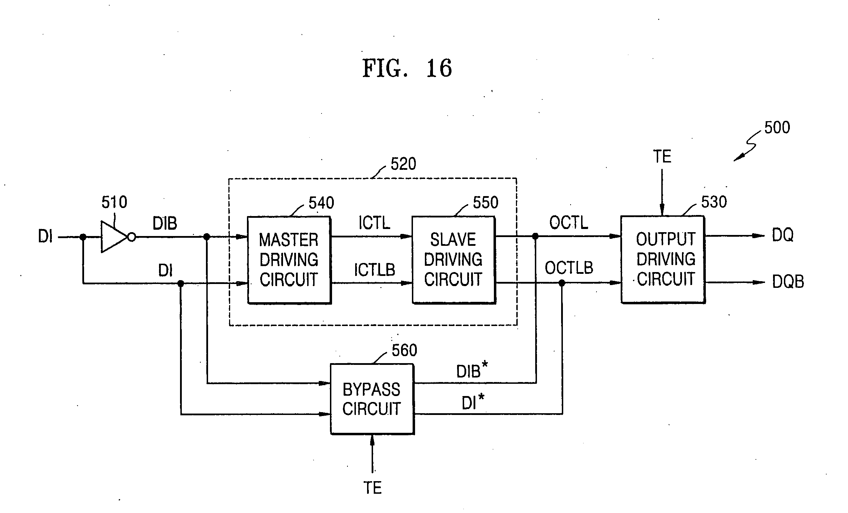

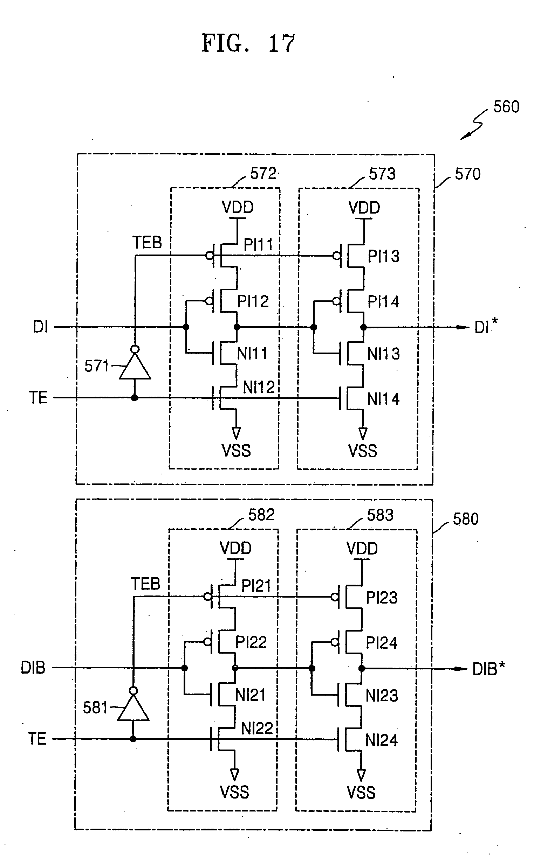

FIG. 16 is an electrical schematic of a differential multi-stage output driver **500** having multiple stages and a differential bypass circuit, according to embodiments of the present invention. This output driver **500** incorporates a differential bypass circuit **560,** which is related to the bypass circuit **240** of FIG. 7, and a plurality of stages that process differential signals in a manner similar to the stages illustrated in FIG. 9. An electrical schematic of the bypass circuit **560** is illustrated in detail in FIG. 17. The multi-stage output driver **500** includes a buffer **510** (e.g., inverter), a control driver stage **520** and an output driver stage **530.** The control driver stage **520** includes an input driver stage **540,** shown as a master driver, and an intermediate driver stage **550,** shown as a slave driver. The master driver **540** generates a pair of control signals ICTL and ICTLB in response to a pair of data input signals DIB and DI and the slave driver **550** generates a pair of control signals OCTL and OCTLB in response to the pair of control signals ICTL and ICTLB. Neither the master driver **540** nor the slave driver **550** is responsive to a test enable signal TE, which means the control signals ICTL and ICTLB will have reduced swing widths during both normal and test modes of operation. The control signals OCTL and OCTLB are provided to the output driver **530,** which generates a pair of data output signals DQ and DQB and is responsive to the test enable signal TE. The signal swing widths of the data output signals DQ and DQB can be maintained at full rail-to-rail levels during the test mode of operation when the signal swing widths of the control signals OCTL and OCTLB are increased by the bypass circuit **560.**

Accordingly, the differential multi-stage output driver **500** is responsive to a pair of input signals (OCTL, OCTLB) and a swing width control signal TE. The output driver **500** configured to generate a pair of output signals (DQ, DQB) having a first swing width when the swing width control signal designates a normal mode of operation and a second swing width greater than the first swing width when the swing width control signal designates a test mode of operation. As illustrated by FIG. 10, the output driver may include a comparing circuit **412** responsive to the pair of input signals, a load circuit **411** and a current source **413.** The current source **413** includes a primary current source **414** and a secondary current source **415.** A multi-stage driver **520** and a multi-stage bypass buffer **560** are also provided to control the swing widths of the input signals OCTL, OCTLB.

As will now be described in detail with respect to FIG. 17, the bypass circuit **560** includes a true bypass circuit **570** and a complementary bypass circuit **580.** The true bypass circuit **570** includes a buffer **571,** a first stage **572** and a second stage **573.** The complementary bypass circuit **580** includes a buffer **581,** a first stage **582** and a second stage **583.** The first stage **572** includes a totem pole arrangement of PMOS and NMOS transistors, which are shown as PI11, PI12, NI11, NI12. The second stage **573** includes a totem pole arrangement of PMOS and NMOS transistors, which are shown as P113, PI14, N113, N114. The first stage **582** includes a totem pole arrangement of PMOS and NMOS transistors, which are shown as PI21, PI22, NI21, NI22. The second stage **583** includes a totem pole arrangement of PMOS and NMOS transistors, which are shown as PI23, PI24, NI23, NI24.

Each of these stages is responsive to the test enable signal TE. Setting the test enable signal TE to an inactive level (i.e., TE=0) causes the true data output DI* of the true bypass circuit **570** and the complementary data output DIB* of the complementary bypass circuit **580** to enter high impedance states. In particular, setting the test enable signal TE to an inactive level disables NMOS transistors NI12, NI14, NI22 and NI24 and disables PMOS transistors PI11, PI13, PI21 and PI23, which are responsive to signal TEB. Alternatively, setting the test enable signal TE to an active level during a test mode of operation enables the true and complementary bypass circuits **570** and **580** and causes the true and complementary data output signals DI* and DIB* to maintain the full swing widths of the true and complementary data input signals DI and DIB. Referring again to FIG. 16, these true and complementary data output signals DI* and DIB* are provided as inputs to the output driver **530** to thereby enable the output driver **530** to drive the outputs DQ and DQB at full rail-to-rail levels during test more operation.

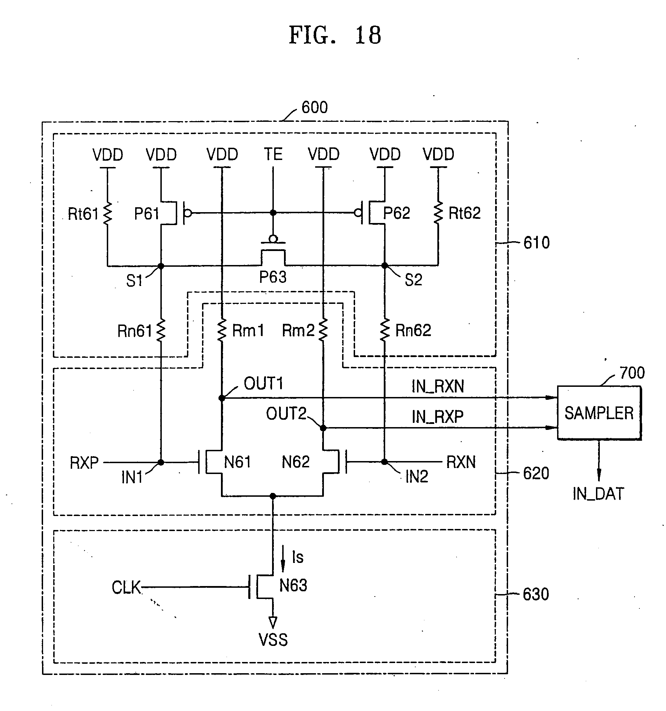

A differential input circuit **600** according to additional embodiments of the present invention is illustrated by FIG. 18, along with an input signal sampler **700.** The differential input circuit **600** includes a load circuit **610,** a comparing circuit **620** and an enable circuit **630.** The enable circuit **630** includes an NMOS pull-down transistor N63, which is responsive to a clock signal CLK. The comparing circuit **620** includes first and second NMOS input transistors N61 and N62. The gate terminal of the first NMOS input transistor N61 is connected to input node IN1, which receives a true input signal RXP. The gate terminal of the second NMOS input transistor N62 is connected to input node IN2, which receives a complementary input signal RXN. The drain terminals of the NMOS input transistors N61 and N62 are connected to the output nodes OUT1 and OUT2. From these nodes, the output signals IN_RXN and IN_RXP are produced and provided as inputs to a sampler circuit **700,** which generates a data input signal IN_DAT. The drain terminals of the NMOS input transistors N61 and N62 are also connected to the resistors Rm1 and Rm2, which are directly connected to the power supply line Vdd.

The load circuit **610** includes normal mode resistors Rn61 and Rn62, which influence the swing widths of the input signals RXP and RXN. The resistor Rn61 is connected to node S1 and the resistor Rn62 is connected to node S2. PMOS equalization transistor P63 has source and drain terminals connected to the nodes S1 and S2, as illustrated. Node S1 is also connected to a termination resistor Rt61 and a drain terminal of PMOS pull-up transistor P61. Node S2 is also connected to a termination resistor Rt62 and a PMOS pull-up transistor P62. The PMOS transistors P61, P62 and P63 are responsive to the test enable signal TE. When the test enable signal TE is set to an inactive level, the termination resistors Rt61 and Rt62 are effectively removed from the load circuit **610** and nodes S1 and S2 are pulled directly to the power supply voltage Vdd. Setting the nodes S1 and S2 to the power supply voltage Vdd will limit the swing widths of the input signals RXP and RXN and thereby limit the swing widths of the output signals IN_RXN and IN_RXP. In contrast, when the test enable signal TE is set to an active level (i.e., TE=1), the PMOS transistors P61, P62 and P63 are turned off. Accordingly, the pull-up path defined by the termination resistor Rt61 and the normal mode resistor Rn61 operates as a voltage divider to thereby preserve a full swing width of the input signal RXP (and output signal IN_RXN). Similarly, the pull-up path defined by the termination resistor Rt62 and the normal mode resistor Rn62 operates as a voltage divider to thereby preserve a full swing width of the input signal RXN (and output signal IN_RXP).

In the drawings and specification, there have been disclosed typical preferred embodiments of the invention and, although specific terms are employed, they are used in a generic and descriptive sense only and not for purposes of limitation, the scope of the invention being set forth in the following claims.

## Claims

1. A high speed input circuit of a semiconductor device, the circuit comprising:
a current source circuit generating a source current in response to a clock signal;
a comparing circuit comparing external signals received from outside through input nodes in response to the source current, and outputting the input signals through output nodes according to the comparison result; and
a termination circuit forming a path, through which an internal voltage is supplied to the comparing circuit, by being connected to the input nodes, and changing impedance values at the input nodes in response to the swing width control signal,
wherein when the impedance values at the input nodes are changed, the voltage swing widths of the external signals are changed.

2. The high speed input circuit of claim 1, wherein the termination circuit comprises:
first termination resistors connected between the input nodes and switching nodes;
second termination resistors connecting to the switching nodes, and forming a path, through which the internal voltage is supplied to the comparing circuit via the first termination resistors;
first switching circuits connecting to the switching nodes in parallel to the second termination resistors, being turned on/off in response to the swing width control signal, and supplying the internal voltage to the comparing circuit through the first termination resistors when it is turned on; and
a second switching circuit connecting between the switching nodes, and being turned on/off in response to the swing width control signal.
